# EUROPÄISCHE PATENTSCHRIFT

(11) **EP 3 600 783 B1**
(45) Veröffentlichungstag und Bekanntmachung des Hinweises auf die Patenterteilung: **05.05.2021**
(21) Anmeldenummer: 18708392.8
(22) Anmeldetag: 28.02.2018
(51) Int. Cl.: B25F 5/02

(54) **ELEKTRONIKMODUL, INSBESONDERE FÜR EINE HANDWERKZEUGMASCHINE**
ELECTRONIC MODULE, IN PARTICULAR FOR A HAND-HELD POWER TOOL
MODULE ÉLECTRONIQUE, EN PARTICULIER POUR MACHINE-OUTIL PORTATIVE

(30) Priorität: 29.03.2017 DE 102017205310
(43) Veröffentlichungstag der Anmeldung: 05.02.2020
(73) Patentinhaber: Robert Bosch GmbH, 70442 Stuttgart (DE)
(72) Erfinder: SCHADOW, Joachim, 70563 Stuttgart (DE); STOCK, Joern, 70711 Leinfelden-Echterdingen (DE); ESENWEIN, Florian, 70771 Leinfelden-Echterdingen (DE)
(86) Internationale Anmeldenummer: PCT/EP2018/054878
(87) Internationale Veröffentlichungsnummer: WO 2018/177671

(56) Entgegenhaltungen:
- EP-A1- 2 072 192
- WO-A2-2013/014914
- JP-A- S6 099 508
- US-A1- 2005 280 393
- US-A1- 2008 135 272
- US-A1- 2010 096 151
- US-A1- 2016 311 094

## Beschreibung

### Stand der Technik

Es ist bereits ein Elektronikmodul, insbesondere für eine Handwerkzeugmaschine, mit zumindest einer Elektronikeinheit, mit zumindest einer Kontaktierungseinheit, die zumindest ein Kontaktelement umfasst, das zu einer Kontaktierung einer elektrischen Energiequelle und/oder zu einer Übertragung von elektronischen Daten vorgesehen ist, und mit zumindest einer Deckeleinheit, wobei die Elektronikeinheit unverlierbar mit der zumindest einen Deckeleinheit verbunden ist, vorgeschlagen worden. Beispiele sind aus der US2016/311094A1, US2005/280393A1, WO2013/014914A2, US2008/135272A1 oder US2010/096151 A1 bekannt.

### Offenbarung der Erfindung

Die Erfindung, wie in Anspruch 1 dargestellt, geht aus von einem Elektronikmodul, insbesondere für eine Handwerkzeugmaschine, mit zumindest einer Elektronikeinheit, mit zumindest einer Kontaktierungseinheit, die zumindest ein Kontaktelement umfasst, das zu einer Kontaktierung einer elektrischen Energiequelle und/oder zu einer Übertragung von elektronischen Daten vorgesehen ist, und mit zumindest einer Deckeleinheit, wobei die Elektronikeinheit unverlierbar mit der zumindest einen Deckeleinheit verbunden ist.

Es wird vorgeschlagen, dass die zumindest eine Kontaktierungseinheit zumindest ein Fixierelement umfasst, das zu einer mechanischen Fixierung der Deckeleinheit, insbesondere an einem Werkzeug, vorgesehen ist, wobei das zumindest eine Kontaktelement zumindest teilweise am zumindest einen Fixierelement angeordnet ist. Dadurch kann das Elektronikmodul besonders kompakt und stabil ausgebildet werden.

Vorzugsweise weist das Elektronikmodul, insbesondere die Elektronikeinheit, zumindest einen Transistor, besonders bevorzugt zumindest einen Mikroprozessor auf. Besonders bevorzugt weist das Elektronikmodul, insbesondere die Elektronikeinheit, zumindest eine Recheneinheit auf. Unter einer "Recheneinheit" soll insbesondere eine Einheit mit einem Informationseingang, einer Informationsverarbeitung und einer Informationsausgabe verstanden werden. Vorteilhaft weist die Recheneinheit zumindest einen Prozessor, einen Speicher, Ein- und Ausgabemittel, weitere elektrische Bauteile, ein Betriebsprogramm, Regelroutinen, Steuerroutinen und/oder Berechnungsroutinen auf. Vorzugsweise sind die Bauteile der Recheneinheit auf einer gemeinsamen Platine, insbesondere der Elektronikeinheit, angeordnet und/oder vorteilhaft in einem gemeinsamen Gehäuse angeordnet. Vorzugsweise weist das Elektronikmodul zumindest eine Sensoreinheit zu einer Erfassung einer bedienerspezifischen und/oder einer werkzeugspezifischen Kenngröße auf. Unter einer "Sensoreinheit" soll in diesem Zusammenhang insbesondere eine Einheit verstanden werden, die dazu vorgesehen ist, zumindest eine Kenngröße und/oder eine physikalische Eigenschaft aufzunehmen, wobei die Aufnahme aktiv, wie insbesondere durch Erzeugen und Aussenden eines elektrischen Messsignals, und/oder passiv, wie insbesondere durch eine Erfassung von Eigenschaftsänderungen eines Sensorbauteils, stattfinden kann.

Vorzugsweise weist das Elektronikmodul, insbesondere die Elektronikeinheit, zumindest eine Ausgabeeinheit zu einer Ausgabe zumindest einer optischen, akustischen und/oder haptischen Information auf. Bevorzugt weist die Ausgabeeinheit zumindest eine Leuchtdiode, einen Lichtleiter, ein Anzeigefeld, ein Display, einen Summer, einen Lautsprecher, ein Vibrationselement und/oder ein weiteres, einem Fachmann als sinnvoll erscheinendes Ausgabeelement auf.

Vorzugsweise weist das Elektronikmodul, insbesondere die Elektronikeinheit, zumindest eine Eingabeeinheit auf, die insbesondere einen Schalter, einen Knopf, eine berührungs- und/oder näherungssensitive Fläche, ein Mikrofon oder ein weiteres, einem Fachmann als sinnvoll erscheinendes Bedienelement umfasst.

Vorzugsweise weist das Elektronikmodul, insbesondere die Elektronikeinheit, zumindest eine Kommunikationseinheit, insbesondere eine NFC-Kommunikationseinheit, zu einer kabelgebundenen und/oder drahtlosen Datenübertragung, insbesondere mit einem Werkzeug und/oder einer Handwerkzeugmaschine, auf. Vorzugsweise ist die Kommunikationseinheit als Sende- und/oder Empfangseinheit zu einer Übertragung von elektronischen Daten ausgebildet. Das Elektronikmodul weist bevorzugt zumindest zwei Sende- und/oder Empfangseinheiten oder Informationseinheiten auf, insbesondere zumindest eine NFC-Sende- und/oder Empfangseinheit und eine Bluetooth- Sende- und/oder Empfangseinheit. Alternativ oder zusätzlich umfasst das Elektronikmodul zumindest eine oder mehrere Informationseinheit/en, wie beispielsweise einen QR-Code, einen Datamatrixcode o. dgl. Vorzugsweise ist zumindest eine der zumindest zwei Sende- und/oder Empfangseinheiten, insbesondere eine NFC-Sende- und/oder Empfangseinheit, zu einem schnellen Verbindungsaufbau zwischen dem Elektronikmodul und einer externen Einheit, insbesondere der Handwerkzeugmaschine, vorgesehen. Bevorzugt ist zumindest eine der zumindest zwei Sende- und/oder Empfangseinheiten, insbesondere eine Bluetooth -Sende- und/oder Empfangseinheit, zu einer Datenübertragung, insbesondere zu einer Übertragung einer Vielzahl an Daten in einer kurzen Zeitspanne, zwischen dem Elektronikmodul und einer externen Einheit, insbesondere der Handwerkzeugmaschine, vorgesehen. Vorzugsweise ist eine Antenne der Kommunikationseinheit derart am Elektronikmodul angeordnet, dass eine Hauptabstrahlungsrichtung der Antenne in Richtung der Deckeleinheit erfolgen kann.

Das Werkzeug kann in diesem Zusammenhang insbesondere eine Maschine, insbesondere eine Handwerkzeugmaschine, eine Arbeitskleidung und/oder ein technisches Hilfsmittel, wie insbesondere ein Armband und/oder eine Armbanduhr ausbilden. Unter einer "Handwerkzeugmaschine" soll insbesondere eine werkstückbearbeitende Maschine, vorteilhaft jedoch eine Bohrmaschine, ein Bohr- und/oder Schlaghammer, eine Säge, ein Hobel, ein Schrauber, eine Fräse, ein Trennschleifer, ein Winkelschleifer, ein Schneidwerkzeug, ein Fliesenschneider, ein Gartengerät und/oder ein Multifunktionswerkzeug verstanden werden.

Vorzugsweise ist das Elektronikmodul mechanisch und/oder elektrisch mit der Handwerkzeugmaschine verbindbar, insbesondere ist das Elektronikmodul an der Handwerkzeugmaschine mittels eines, bevorzugt lösbaren, Haltemechanismus anordenbar. Ferner ist denkbar, dass die Kommunikationseinheit zu einem Datenaustausch mit einem externen Gerät wie beispielsweise einem Smartphone, einem Tablet, einem PC und/oder Ähnlichem vorgesehen ist, insbesondere zu einer Steuerung des Elektronikmoduls, zu einem Firmware-Upgrade, zu einem Auslesen des Elektronikmoduls oder zu einer weiteren, einem Fachmann als sinnvoll erscheinenden Funktion.

Vorzugsweise weist ein das Elektronikmodul umfassendes System zumindest ein Abschirmelement, insbesondere eine Kunststoffplatte oder ein Distanzelement, auf, das dazu vorgesehen ist, eine Entkopplung und/oder eine Abschirmung des Elektronikmoduls vor thermischen und/oder mechanischen Einflüssen zu realisieren. Ferner ist denkbar, dass das Elektronikmodul zu einer Erhöhung und/oder zu einer Dämpfung einer abgestrahlten Sendeleistung der Kommunikationseinheit zumindest ein Reflexionselement, insbesondere eine Kunststoffplatte, aufweist, das dazu vorgesehen ist, eine auf das Reflexionselement einfallende elektromagnetische Strahlung zu reflektieren, zu bündeln und/oder eine bevorzugte Ausbreitung einer ausgesandten Strahlung zu ermöglichen. Das Reflexionselement und/oder das Abschirmelement weisen/weist vorzugsweise eine maximale Stärke auf, die insbesondere kleiner ist als 15 mm, bevorzugt kleiner ist als 10 mm und besonderes bevorzugt kleiner ist als 5 mm. Vorteilhafterweise weisen/weist das Reflexionselement und/oder das Abschirmelement eine maximale Stärke auf, die insbesondere einem Wert aus einem Wertebereich von 1 mm bis 10 mm, bevorzugt einem Wert aus einem Wertebereich von 1 mm bis 6 mm und besonders bevorzugt einem Wert aus einem Wertebereich von 2 mm bis 3 mm entspricht. Vorzugsweise sind/ist das Reflexionselement und/oder das Abschirmelement zwischen einer Außenfläche des Gehäuses, insbesondere einer Außenfläche eines Bodens, des Elektronikmoduls und zumindest einem Antennenelement der Kommunikationseinheit des Elektronikmoduls angeordnet.

Des Weiteren ist denkbar, dass in dem Elektronikmodul, insbesondere der Elektronikeinheit, einsatzspezifische und/oder handwerkzeugmaschinenspezifische Informationen hinterlegt sind. Basierend auf den einsatzspezifischen und/oder handwerkzeugmaschinenspezifischen Informationen kann das Elektronikmodul in Abhängigkeit von einer Verwendung der Handwerkzeugmaschine Anweisungen und/oder Hinweise an einen Benutzer ausgeben. Beispielsweise ist denkbar, dass ein Benutzer eine auszuführende Tätigkeit mittels einer Eingabeeinheit oder mittels Datenübertragung an eine Kommunikationseinheit an das Elektronikmodul übermittelt und das Elektronikmodul daraufhin ein für die auszuführende Tätigkeit geeignetes Werkzeug, insbesondere eine Handwerkzeugmaschine, vorschlägt. Weiterhin ist denkbar, dass das Elektronikmodul unabhängig von einer Kommunikation mit der Handwerkzeugmaschine und/oder einer externen Einheit Daten erfassen, verarbeiten und/oder speichern kann, die beispielsweise nach einem elektronikmoduleigenen Erfassen, Verarbeiten und/oder Speichern auslesbar sind, insbesondere mittels einer kabelgebundenen und/oder einer kabellosen Datenverbindung mit einem Gateway, einer Auslesevorrichtung o. dgl.

Unter einer "Kontaktierungseinheit" soll insbesondere eine Einheit verstanden werden, die zumindest ein Kontaktierungselement, zu einer elektrischen Kontaktierung des Elektronikmoduls und/oder zu einer Datenübertragung und/oder zu einer Übertragung von elektrischer Energie zu einem Betrieb zumindest der Elektronikeinheit bereitstellt. Die Kontaktierungseinheit ist drahtlos und/oder bevorzugt kabelgebunden ausgebildet. Weiterhin ist denkbar, dass die Kontaktierungseinheit zumindest teilweise als Einheit mit einer Kommunikationseinheit des Elektronikmoduls ausgebildet ist. Vorzugsweise ist zumindest ein Kontaktierungselement als eine Kontaktlasche, eine Kontaktfeder, ein Kontaktclip oder ein weiteres, einem Fachmann als sinnvoll erscheinendes Kontaktierungselement ausgebildet.

Unter einer "Deckeleinheit" soll insbesondere eine Einheit verstanden werden, die zumindest eine Seite der Elektronikeinheit und/oder der Kontaktierungseinheit bedeckend vor einer Berührung schützt und/oder die zumindest eine Öffnung, insbesondere zumindest eine Gehäuseöffnung eines Gehäuses des Elektronikmoduls oder eines Gehäuses der Handwerkzeugmaschine, verschließt.

Vorzugsweise weist die Deckeleinheit bezogen auf ein die Deckeleinheit zumindest teilweise aufnehmendes Gehäuse, eine geringe statische Wirkung auf, da insbesondere das die Deckeleinheit zumindest teilweise aufnehmende Gehäuse weitestgehend eine Statikfunktion erfüllt und/oder zu einer Abstützung von auf die Deckeleinheit einwirkenden Kräften vorgesehen ist.

Vorzugsweise weist die Deckeleinheit an einer der Elektronikeinheit abgewandten Seite eine geschlossene Oberfläche auf, welche sich insbesondere über die Elektronikeinheit und/oder die Kontaktierungseinheit erstreckt. Vorzugsweise sind die Eingabeeinheit und/oder die Ausgabeeinheit zumindest teilweise an der Deckeleinheit, insbesondere an einer der Elektronikeinheit abgewandten Seite der Deckeleinheit, angeordnet. Mittels einer Ausrichtung und/oder Anordnung der Elektronikeinheit an der Deckeleinheit kann vorteilhaft eine kurze Verbindungsstrecke zu einer Verkabelung der Eingabeeinheit und/oder der Ausgabeeinheit erreicht werden. Beispielsweise kann auch vorteilhaft eine/ein direkt an einer als Leiterplatte ausgebildete Elektronikeinheit angeordnete LED oder angeordnetes Display konstruktiv einfach nach außen geführt werden, insbesondere auf eine der Elektronikeinheit abgewandte Seite der Deckeleinheit. Die elektrische Energiequelle ist bevorzugt von einer Knopfzelle, insbesondere eine Knopfzelle mit der Größe 2450 oder 2032 oder einem Pouch-Pack mit zum Beispiel Lithium-Polymer-Akkumulatoren gebildet.

Das Fixierelement bildet vorzugsweise ein Formschlusselement und/oder ein Kraftschlusselement aus. Es ist in diesem Zusammenhang denkbar, dass das Fixierelement ein Steckelement, ein Gewinde oder ein Rastmittel ausbildet. Das Fixierelement ist insbesondere zu einer Fixierung der Deckeleinheit mit einem Werkzeug, einer Gehäuseeinheit und/oder einer Erweiterungseinheit vorgesehen. Unter "vorgesehen" soll insbesondere speziell programmiert, ausgelegt und/oder ausgestattet verstanden werden. Darunter, dass ein Objekt zu einer bestimmten Funktion vorgesehen ist, soll insbesondere verstanden werden, dass das Objekt diese bestimmte Funktion in zumindest einem Anwendungs- und/oder Betriebszustand erfüllt und/oder ausführt.

In einer weiteren Ausgestaltung der Erfindung wird vorgeschlagen, dass das zumindest eine Kontaktelement zu einer axialen Kontaktierung mit der elektrischen Energiequelle und/oder einer weiteren Elektronikeinheit vorgesehen ist. Dadurch kann eine besonders hohe Kontaktsicherheit erzielt werden. Die weitere Elektronikeinheit ist vorzugsweise von einer separaten Erweiterungseinheit, von einer Erweiterungseinheit, von einer Werkzeugelektronikeinheit des Werkzeugs und/oder von einer elektrischen Energiequelle gebildet. Unter einer "axialen Kontaktierung" soll in diesem Zusammenhang insbesondere eine Kontaktierung in eine Axialrichtung und/oder über Kontaktflächen verstanden werden, die zumindest im Wesentlichen senkrecht zur Axialrichtung verlaufen. Die Axialrichtung verläuft insbesondere parallel zu einer Zylinderachse eines gedachten Zylinders mit kleinstmöglichem Radius, der die Deckeleinheit gerade noch umschließt. Unter "zumindest im Wesentlichen" soll in diesem Zusammenhang insbesondere mit einer Abweichung von maximal 20°, bevorzugt von maximal 5°, besonders bevorzugt von maximal 1° verstanden werden.

Des Weiteren wird vorgeschlagen, dass das zumindest eine Kontaktelement zu einer radialen Kontaktierung mit der elektrischen Energiequelle und/oder einer weiteren Elektronikeinheit vorgesehen ist. Dadurch kann eine besonders hohe Kontaktsicherheit erzielt werden. Unter einer "radialen Kontaktierung" soll in diesem Zusammenhang insbesondere eine Kontaktierung in eine Radialrichtung und/oder über Kontaktflächen verstanden werden, die zumindest im Wesentlichen senkrecht zur Radialrichtung verlaufen. Die Radialrichtung verläuft insbesondere zumindest im Wesentlichen senkrecht zur Axialrichtung.

Weiterhin wird vorgeschlagen, dass das Elektronikmodul zumindest eine Erweiterungseinheit umfasst, die mit der zumindest einen Elektronikeinheit koppelbar ausgebildet ist und die zu einer Funktionserweiterung der zumindest einen Elektronikeinheit vorgesehen ist. Alternativ und/oder zusätzlich wird vorgeschlagen, dass die zumindest eine Erweiterungseinheit mit der zumindest einen Elektronikeinheit austauschbar ausgebildet ist und die zu einer Funktionserweiterung und/oder Funktionsänderung der zumindest einen Elektronikeinheit vorgesehen ist. Dadurch kann das Elektronikmodul vorteilhaft nachträglich um Funktionen, wie insbesondere neu entwickelte Datenübertragungsstandards, erweitert werden. Eine Lebensdauer des Elektronikmoduls kann somit vorteilhaft verlängert werden. Bevorzugt umfasst die zumindest eine Erweiterungseinheit zumindest eine Datenerfassungseinheit, einen Datenspeicher, eine Datenauswerteeinheit und/oder eine Datenausgabeeinheit.

Außerdem wird vorgeschlagen, dass die zumindest eine Erweiterungseinheit zumindest ein Bodenelement aufweist, das zumindest zu einem Verschließen eines Aufnahmeraums vorgesehen ist, in welchem die zumindest eine Elektronikeinheit angeordnet ist. Dadurch kann die Elektronikeinheit besonders vorteilhaft vor äußeren Einflüssen geschützt werden. Ferner kann das Elektronikmodul vorteilhaft kompakt ausgebildet werden.

Zudem wird vorgeschlagen, dass die zumindest eine Erweiterungseinheit zumindest eine Kommunikationseinheit umfasst, die zu einer drahtlosen Datenübertragung vorgesehen ist. Dadurch können Daten vorteilhaft mit einer Werkzeugelektronikeinheit und/oder besonders vorteilhaft mit einem externen Gerät wie beispielsweise einem Smartphone, einem Tablet und/oder einem PC ausgetauscht werden. Vorteilhaft ist die Kommunikationseinheit zu einer drahtlosen Kommunikation, insbesondere nach einem Standard der IEEE-802.11-Familie, nach einem Standard nach IEEE 802.15.1, nach einem Standard nach IEEE 802.15.4, nach einem ZigBee-Standard, nach einem RFID-Standard und/oder einem NFC-Standard vorgesehen. Es ist in diesem Zusammenhang auch denkbar, dass die Kommunikationseinheit zu einer kabelgebundenen Kommunikation, insbesondere nach einem Standard nach IEEE-802.3 vorgesehen ist. Vorzugsweise ist zwischen, insbesondere axial zwischen, der zumindest einen Elektronikeinheit und der zumindest einen Erweiterungseinheit zumindest eine elektrische Energiequelle, bevorzugt eine Knopfzelle, angeordnet.

Ferner wird vorgeschlagen, dass die zumindest eine Kontaktierungseinheit zumindest ein Steckverbindungselement umfasst, an welchem das zumindest eine Kontaktelement angeordnet ist. Dadurch kann eine besonders sichere Kontaktierung, insbesondere zwischen der zumindest einen Elektronikeinheit und der zumindest einen Erweiterungseinheit erzielt werden. Das Steckverbindungselement bildet vorzugsweise ein Steckerelement und/oder ein Buchsenelement aus. Besonders vorteilhaft ist das zumindest eine Steckverbindungselement einstückig mit der Deckeleinheit ausgebildet.

Des Weiteren wird vorgeschlagen, dass das zumindest eine Kontaktelement zumindest teilweise innerhalb einer Deckelwandung der zumindest einen Deckeleinheit angeordnet ist. Dadurch kann das zumindest eine Kontaktelement besonders gut vor Beschädigungen geschützt werden. Vorzugsweise ist das zumindest eine Kontaktelement zumindest teilweise in die Deckelwandung der zumindest einen Deckeleinheit eingespritzt.

Weiterhin wird vorgeschlagen, dass das zumindest eine Fixierelement einen Bajonettverschluss ausbildet. Dadurch kann eine besonders einfache und sichere Fixierung der Deckeleinheit an einem Werkzeug und/oder an einer Gehäuseeinheit erzielt werden.

Ferner wird ein Werkzeug, insbesondere eine Handwerkzeugmaschine, mit einem erfindungsgemäßen Elektronikmodul vorgeschlagen. Hierdurch können Funktionen des Werkzeugs besonders vorteilhaft auf einfache Weise erweitert werden.

### Zeichnung

Weitere Vorteile ergeben sich aus der folgenden Zeichnungsbeschreibung. In der Zeichnung sind drei Ausführungsbeispiele der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- Fig. 1: ein Werkzeug mit einem Elektronikmodul in einer perspektivischen Darstellung,
- Fig. 2: ein erstes Ausführungsbeispiel des Elektronikmoduls in einer perspektivischen Schnittdarstellung,
- Fig. 3: eine Deckeleinheit und eine Elektronikeinheit des Elektronikmoduls in einer schematischen perspektivischen Darstellung,
- Fig. 4: eine Deckeleinheit und eine Elektronikeinheit eines weiteren Ausführungsbeispiels eines Elektronikmoduls in einer schematischen perspektivischen Darstellung,
- Fig. 5: eine Deckeleinheit und eine Elektronikeinheit eines weiteren Ausführungsbeispiels eines Elektronikmoduls in einer schematischen perspektivischen Darstellung und
- Fig. 6: die Elektronikmodule der Ausführungsbeispiele und korrespondierende Werkzeuge in einer schematischen Darstellung.

### Beschreibung der Ausführungsbeispiele

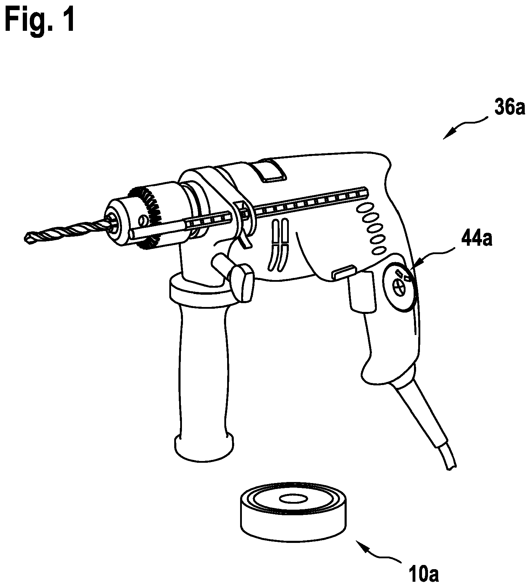

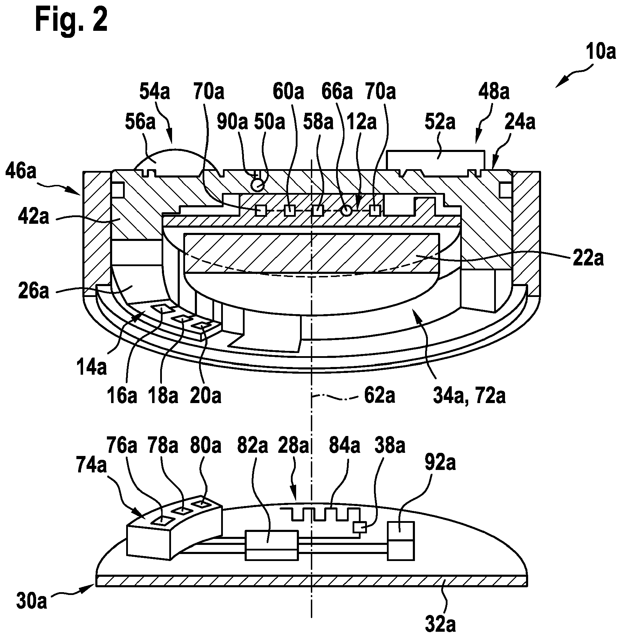

Die Figur 1 zeigt ein erstes Ausführungsbeispiel eines Elektronikmoduls 10a und ein Werkzeug 36a. Das Werkzeug 36a bildet eine Handwerkzeugmaschine aus. Das Werkzeug 36a weist eine als Aufnahmebereich für das Elektronikmodul 10a ausgebildete Basiseinheit 44a auf. Das Werkzeug 36a weist ein nicht näher dargestelltes, an dem Aufnahmebereich angeordnetes Kontaktmittel zu einer elektrischen Kontaktierung einer Kontaktierungseinheit 14a des Elektronikmoduls 10a auf (Figur 2). Zwischen dem Werkzeug 36a und dem Elektronikmodul 10a sind mittels des Kontaktmittels und der Kontaktierungseinheit 14a Daten und/oder elektrische Energie zu einem Betrieb des Elektronikmoduls 10a übertragbar. Das Elektronikmodul 10a ist in der als Aufnahmebereich für das Elektronikmodul 10a ausgebildeten Basiseinheit 44a lösbar befestigt.

Die Kontaktierungseinheit 14a umfasst ein Fixierelement 26a. Das Fixierelement 26a ist zu einer mechanischen Fixierung einer Deckeleinheit 24a des Elektronikmoduls 10a am Werkzeug 36a vorgesehen. Alternativ und/oder zusätzlich ist das Fixierelement 26a zu einer mechanischen Fixierung der Deckeleinheit 24a an einer Gehäuseeinheit 46a des Elektronikmoduls 10a vorgesehen. Die Gehäuseeinheit 46a umschließt die Deckeleinheit 24a in eine Radialrichtung betrachtet vollständig.

Die Kontaktierungseinheit 14a umfasst ein weiteres Fixierelement 86a. Das weitere Fixierelement 86a weist eine gleiche konstruktive Ausgestaltung wie das Fixierelement 26a auf. Das Fixierelement 26a und das weitere Fixierelement 86a sind in eine Umfangsrichtung betrachtet um 180° zueinander versetzt angeordnet. In anderen Worten sind das Fixierelement 26a und das weitere Fixierelement 86a drehsymmetrisch zueinander angeordnet.

Es kann vorteilhaft bei einer Anordnung des Elektronikmoduls 10a am Werkzeug 36a ein Kontakt zu einer Übertragung von elektrischer Energie und/oder zu einer Übertragung von elektronischen Daten zwischen dem Werkzeug 36a und dem Elektronikmodul 10a ermöglicht werden. Das Elektronikmodul 10a umfasst eine Elektronikeinheit 12a. Das Elektronikmodul 10a, insbesondere die Elektronikeinheit 12a des Elektronikmoduls 10a, umfasst eine Ausgabeeinheit 48a. Die Ausgabeeinheit 48a umfasst als Leuchtdioden ausgebildete Ausgabeelemente 50a, 52a. Es ist jedoch auch denkbar, dass die Ausgabeeinheit 48a alternativ oder zusätzlich zumindest ein Ausgabeelement aufweist, das als Display, als Lautsprecher, Minidisplay o. dgl. ausgebildet ist. Eine Lichtinformation des Ausgabeelements 50a wird über einen Lichtleiter 90a der Ausgabeeinheit 48a auf eine Oberfläche des Elektronikmoduls 10a geführt.

Das Elektronikmodul 10a, insbesondere die Elektronikeinheit 12a, umfasst eine Eingabeeinheit 54a. Die Eingabeeinheit 54a umfasst ein als Bedienknopf oder - schalter ausgebildetes Bedienelement 56a. Es ist jedoch auch denkbar, dass die Eingabeeinheit 54a alternativ oder zusätzlich zumindest ein Bedienelement aufweist, das als berührungsempfindliches oder als näherungsempfindliches Bedienelement, LED-Drucktaster, -folien o. dgl. ausgebildet ist. Eine Bestückungsseite des Elektronikmoduls 10a ist in Richtung der Deckeleinheit 24a orientiert. Die Ausgabeeinheit 48a und/oder die Eingabeeinheit 54a durchdringen die Deckeleinheit 24a bereichsweise.

In einer Ausbaustufe umfasst die Ausgabeeinheit 48a z.B. LEDs, einen Summer, eine Sirene o. dgl.. Damit kann einem Anwender ein Zustand/Status z.B. eine Warnung etc. übermittelt werden. Auch bei einer Suche nach dem Elektronikmodul 10a kann dieses per Funk kontaktiert werden und meldet sich dann optisch, akustisch oder durch vibrieren. Um z.B. ein Pairing zwischen einem Smartphone und einem Elektronikmodul 10a (z.B. für einen Datenaustausch) starten zu können, kann z.B. die Eingabeeinheit 54a vorgesehen sein, welche zumindest teilweise in die Deckeleinheit 24a integriert ist. Wie bereits ausgeführt, kann die Eingabeeinheit 54a insbesondere einen mechanischen Knopf und/oder einen Mikroschalter o.dgl. umfassen. Alternativ kann die Eingabeeinheit 54a auch einen geeigneten Sensor zur Aktivierung des Pairings umfassen, welcher z.B. durch auf einen bestimmten Bewegungsablauf oder Klopfrhythmus reagiert, um den Pairingvorgang zu initiieren.

Umfasst die Ausgabeeinheit 48a ein Display kann darin ein Menü angezeigt werden und ein Anwender kann sich über die Eingabeeinheit 54a durch das Menü bewegen. Die Ausgabeeinheit 48a kann auch Anzeigeelemente umfassen, welche als hintergrundbeleuchtete Symbole ausgeführt sein können. So kann z.B. der Status einer Funkverbindung, einer Energiespeichereinheit, einer Messgröße eines Sensors z.B. durch Vibrations-Expositionen etc. angezeigt werden. Umfasst die Ausgabeeinheit 48a einen Lichtring, können zudem noch weitere Anzeigen ermöglicht werden, wie z.B. eine Anzeige einer Uhr und/oder eines dynamischen Status, ähnlich einer Tachoanzeige. Bei dieser Art von Anzeigen erkennt der Nutzer sehr leicht, in welchem Messbereich er sich aktuell befindet, z.B. wenn der Kreis als Halbkreis Grafik beleuchtet ist, dass 50% erreicht worden sind etc. oder wenn der Kreis fast voll ausgeleuchtet ist, dass ein Grenzwert, Zielwert bald erreicht wird.

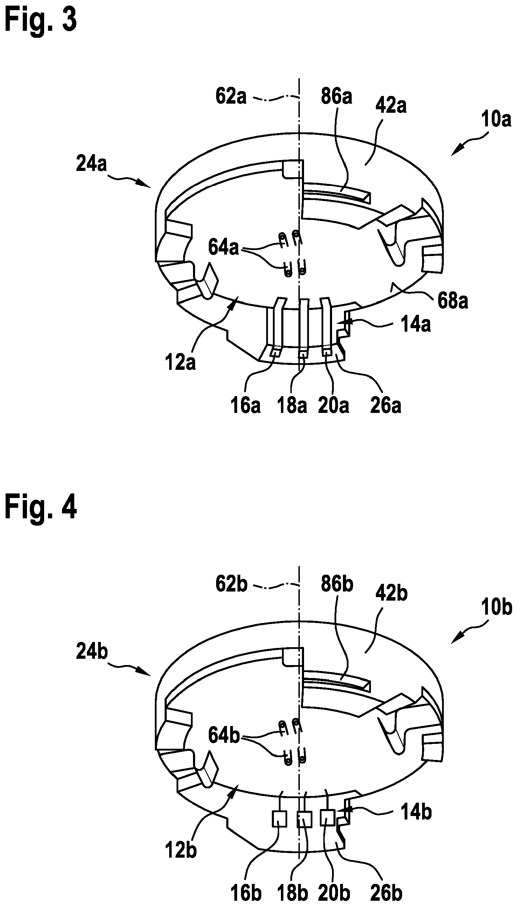

Wie in den Figuren 2 und 3 gezeigt, umfasst die Kontaktierungseinheit 14a drei Kontaktelemente 16a, 18a, 20a. Die Kontaktelemente 16a, 18a, 20a sind teilweise am Fixierelement 26a angeordnet. Das Elektronikmodul 10a, insbesondere die Elektronikeinheit 12a, weist eine Sensoreinheit 58a zu einer Erfassung einer bedienerspezifischen und/oder einer handwerkzeugmaschinenspezifischen Kenngröße auf. Die Kenngröße kann insbesondere Motortemperaturen, Gesamtbetriebsstunden, verwendete Werkzeuge, Lage und/oder Ort der Handwerkzeugmaschine, Beschleunigung und/oder Erschütterung der Handwerkzeugmaschine sowie weitere, einem Fachmann als sinnvoll erscheinende Werte umfassen.

Das Elektronikmodul 10a umfasst eine Recheneinheit 60a. Die Recheneinheit 60a ist zu einer Verarbeitung von Daten der Sensoreinheit 58a, zu einer Verarbeitung von Benutzereingaben der Eingabeeinheit 54a, zu einem Austausch von Daten mit der Ausgabeeinheit 48a und/oder einer Kommunikationseinheit 70a, zu einer Steuerung einer externen Einheit, insbesondere eines Werkzeugs 36a und/oder zu einem Energiemanagement einer elektrischen Energiequelle vorgesehen. Die Kontaktelemente 16a, 18a, 20a bilden Kontaktflächen aus, die sich senkrecht zu einer Axialrichtung 62a erstrecken. Die Kontaktelemente 16a, 18a, 20a sind teilweise innerhalb einer Deckelwandung 42a der Deckeleinheit 24a angeordnet. Die Kontaktelemente 16a, 18a, 20a sind teilweise in die Deckelwandung 42a eingespritzt und/oder vergossen. Die Deckelwandung 42a ist einstückig mit dem Fixierelement 26a ausgebildet. Die Deckelwandung 42a ist einstückig mit dem weiteren Fixierelement 86a ausgebildet.

Die Kontaktierungseinheit 14a ist über Kontaktelemente 64a zu einer Kontaktierung einer elektrischen Energiequelle 22a vorgesehen. Die elektrische Energiequelle 22a ist von einer Knopfzelle gebildet. Die Kontaktierungseinheit 14a umfasst ein zusätzliches Kontaktelement 66a, das zu einer drahtlosen Kontaktierung einer weiteren, nicht dargestellten elektrischen Energiequelle und/oder zu einer drahtlosen Datenübertragung vorgesehen ist.

In der Figur 3 ist die Deckeleinheit 24a und die Elektronikeinheit 12a ohne eine Gehäuseeinheit 46a dargestellt. Die Deckeleinheit 24a weist an einer der Elektronikeinheit 12a abgewandten Seite eine zumindest im Wesentlichen geschlossene Oberfläche auf, die sich über die gesamte Elektronikeinheit 12a erstreckt. Die Elektronikeinheit 12a ist unverlierbar mit der Deckeleinheit 24a verbunden. Die Verbindung zwischen der Elektronikeinheit 12a und der Deckeleinheit 24a kann über eine Steckverbindung, eine Verrastung, ein Bajonett, durch Reibschluss und/oder durch Kraftschluss erfolgen.

Das Fixierelement 26a ist an der Deckeleinheit 24a angeordnet. Das Fixierelement 26a ist zu einer lösbaren Befestigung des Elektronikmoduls 10a an der Basiseinheit 44a vorgesehen. Die Kontaktierungseinheit 14a ist an einer der Deckeleinheit 24a abgewandten Seite 68a der Elektronikeinheit 12a angeordnet. Die Deckeleinheit 24a ist zu einer Halterung der Elektronikeinheit 12a vorgesehen. Die Deckeleinheit 24a weist ein nicht näher gezeigtes Halteelement zu einer Halterung der Elektronikeinheit 12a auf. Das Halteelement fixiert die Elektronikeinheit 12a formschlüssig an der Deckeleinheit 24a. Das Fixierelement 26a bildet einen Bajonettverschluss aus.

Das Elektronikmodul 10a, insbesondere die Elektronikeinheit 12a, weist eine Kommunikationseinheit 70a zu einem drahtlosen Datenaustausch mit einer externen Einheit, insbesondere mit einer Handwerkzeugmaschine, auf. Die Kommunikationseinheit 70a ist als NFC-Kommunikationseinheit ausgebildet. Die Kommunikationseinheit 70a weist ein Kontaktierungselement zu einer Versorgung des Elektronikmoduls 10a mit elektrischer Energie auf, welche insbesondere von der externen Einheit bereitgestellt werden kann. Das Kontaktierungselement ist zu einer drahtlosen Verbindung mit der externen Einheit vorgesehen. Die Kommunikationseinheit 70a ist teilweise als Einheit mit der Kontaktierungseinheit 14a ausgebildet.

Das Elektronikmodul 10a weist einen Energiespeicheraufnahmebereich 72a auf. Der Energiespeicheraufnahmebereich 72a ist an einer der Deckeleinheit 24a abgewandten Seite 68a der Elektronikeinheit 12a angeordnet. Der Energiespeicheraufnahmebereich 72a ist an der Kontaktierungseinheit 14a anliegend angeordnet.

Das Elektronikmodul 10a weist einen Schichtaufbau auf. In einer Richtung, insbesondere der Axialrichtung 62a, von der Deckeleinheit 24a zu der Kontaktierungseinheit 14a gesehen, ist die Elektronikeinheit 12a hinter der Deckeleinheit 24a angeordnet. In der Richtung von der Deckeleinheit 24a zu der Kontaktierungseinheit 14a gesehen, ist die Kontaktierungseinheit 14a hinter der Elektronikeinheit 12a angeordnet. In der Richtung von der Deckeleinheit 24a zu der Kontaktierungseinheit 14a gesehen, ist der Energiespeicheraufnahmebereich 72a hinter der Kontaktierungseinheit 14a angeordnet.

Das Elektronikmodul 10a umfasst optional eine Erweiterungseinheit 30a. Die Erweiterungseinheit 30a umfasst eine weitere Elektronikeinheit 28a. Es ist in diesem Zusammenhang auch denkbar, dass die Erweiterungseinheit 30a einen Energiespeicher umfasst. Die Erweiterungseinheit 30a ist mit der Elektronikeinheit 12a koppelbar ausgebildet. Die Erweiterungseinheit 30a ist zu einer Funktionserweiterung der Elektronikeinheit 12a vorgesehen. Die Kontaktelemente 16a, 18a, 20a sind zu einer axialen Kontaktierung mit der weiteren Elektronikeinheit 28a vorgesehen. In diesem Fall kontaktieren die Kontaktelemente 16a, 18a, 20a nicht die Basiseinheit 44a des Werkzeugs 36a. Diese Kontaktierung kann über nicht näher gezeigte Mittel der Erweiterungseinheit 30a und/oder drahtlos erfolgen. Die Erweiterungseinheit 30a weist ein Bodenelement 32a auf, das zu einem Verschließen eines Aufnahmeraums 34a vorgesehen ist, in welchem die Elektronikeinheit 12a angeordnet ist. In diesem Ausführungsbeispiel entspricht der Aufnahmeraum 34a dem Energiespeicheraufnahmebereich 72a. Die Kontaktelemente 16a, 18a, 20a schließen die Deckeleinheit 18a in Axialrichtung 62a ab.

Die Erweiterungseinheit 30a umfasst eine Kontaktierungseinheit 74a. Die Kontaktierungseinheit 74a weist drei Kontaktelemente 76a, 78a, 80a auf, die zu einer Kontaktierung mit den Kontaktelementen 16a, 18a, 20a der Kontaktierungseinheit 14a des Elektronikmoduls 10a vorgesehen sind. Die Kontaktelemente 76a, 78a, 80a sind deckungsgleich zu den Kontaktelementen 16a, 18a, 20a angeordnet. Die Erweiterungseinheit 30a umfasst einen Sensor 92a, der zu einer Erfassung einer Kenngröße vorgesehen ist.

Die Kontaktierungseinheit 74a ist auf dem Bodenelement 32a angeordnet. Die Erweiterungseinheit 30a umfasst eine Recheneinheit 82a. Die Erweiterungseinheit 30a umfasst eine Kommunikationseinheit 38a. Die Kommunikationseinheit 38a umfasst eine Antenne 84a. Die Antenne 84a ist auf dem Bodenelement 32a angeordnet. Die Kommunikationseinheit 38a ist zu einer drahtlosen Datenübertragung vorgesehen. Die Kommunikationseinheit 38a ist dabei zu einer Datenübertragung nach einem anderen Standard vorgesehen, als die Kommunikationseinheit 70a. Die Elektronikeinheit 12 und die Deckeleinheit 24a können für verschiedene Anwendungen ausgeführt sein. So kann eine Basis-Version darin bestehen, dass z.B. lediglich eine Beacon Funktion über ein Signal und/oder eine Nachricht in regel- und oder unregelmäßigen Abständen mit einem Funkstandard über die Kommunikationseinheit 38a abgesetzt wird. Auf die Ausgabeeinheit 48a kann hierbei verzichtet werden.

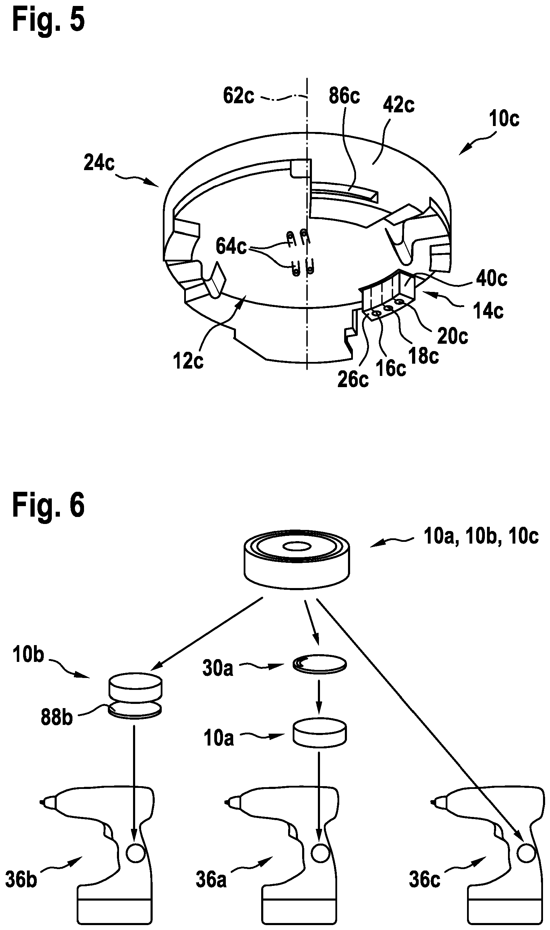

In den Figuren 4 und 5 sind zwei weitere Ausführungsbeispiele der Erfindung gezeigt. Die nachfolgenden Beschreibungen und die Zeichnungen beschränken sich im Wesentlichen auf die Unterschiede zwischen den Ausführungsbeispielen, wobei bezüglich gleich bezeichneter Bauteile, insbesondere in Bezug auf Bauteile mit gleichen Bezugszeichen, grundsätzlich auch auf die Zeichnungen und/oder die Beschreibung der anderen Ausführungsbeispiele, insbesondere der Figuren 1 bis 3, verwiesen werden kann. Zur Unterscheidung der Ausführungsbeispiele ist der Buchstabe a den Bezugszeichen des Ausführungsbeispiels in den Figuren 1 bis 3 nachgestellt. In den Ausführungsbeispielen der Figuren 4 und 5 ist der Buchstabe a durch die Buchstaben b und c ersetzt.

Die Figur 4 zeigt ein Elektronikmodul 10b, insbesondere für eine Handwerkzeugmaschine. Das Elektronikmodul 10b umfasst eine Elektronikeinheit 12b. Das Elektronikmodul 10b umfasst eine Kontaktierungseinheit 14b. Die Kontaktierungseinheit 14b umfasst drei Kontaktelemente 16b, 18b, 20b. Die Kontaktelemente 16b, 18b, 20b sind zu einer Übertragung von elektronischen Daten vorgesehen. Das Elektronikmodul 10b umfasst eine Deckeleinheit 24b. Die Elektronikeinheit 12b ist unverlierbar mit der Deckeleinheit 24b verbunden. Die Kontaktierungseinheit 14b umfasst ein Fixierelement 26b. Das Fixierelement 26b ist zu einer mechanischen Fixierung der Deckeleinheit 24b an einem Werkzeug 36b vorgesehen (Figur 6). Hierzu kann das Elektronikmodul 10b auch von einem Bodenelement 88b, insbesondere ein elektronikfreies Bodenelement 88b, verschlossen werden.

Die Kontaktelemente 16b, 18b, 20b sind teilweise am Fixierelement 26b angeordnet. Die Deckeleinheit 24b weist eine zumindest im Wesentlichen runde Außenkontur auf. Die Deckeleinheit 24b ist zumindest teilweise scheibenförmig ausgebildet. Die Kontaktelemente 16b, 18b, 20b sind zu einer radialen Kontaktierung mit einer weiteren Elektronikeinheit 28b vorgesehen. Es ist in diesem Zusammenhang jedoch auch denkbar, dass die Kontaktelemente 16b, 18b, zu einer radialen Kontaktierung mit einer elektrischen Energiequelle vorgesehen sind. Die Radialrichtung verläuft senkrecht zu einer Axialrichtung 62b, die senkrecht zur scheibenförmigen Deckeleinheit 24b verläuft. Die Axialrichtung 62b verläuft durch einen geometrischen Mittelpunkt der Deckeleinheit 24b.

Das Fixierelement 26b bildet einen Bajonettverschluss aus. Die Kontaktierungseinheit 14b umfasst ein weiteres Fixierelement 86b. Das weitere Fixierelement 86b weist eine gleiche konstruktive Ausgestaltung wie das Fixierelement 26b auf. Das Fixierelement 26b und das weitere Fixierelement 86b sind in eine Umfangsrichtung betrachtet um 180° zueinander versetzt angeordnet. In anderen Worten sind das Fixierelement 26b und das weitere Fixierelement 86b drehsymmetrisch zueinander angeordnet.

Die Figur 5 zeigt ein Elektronikmodul 10c, insbesondere für eine Handwerkzeugmaschine. Das Elektronikmodul 10c umfasst eine Elektronikeinheit 12c. Das Elektronikmodul 10c umfasst eine Kontaktierungseinheit 14c. Die Kontaktierungseinheit 14c umfasst drei Kontaktelemente 16c, 18c, 20c. Die Kontaktelemente 16c, 18c, 20c sind zu einer Übertragung von elektronischen Daten vorgesehen. Das Elektronikmodul 10c umfasst eine Deckeleinheit 24c. Die Elektronikeinheit 12c ist unverlierbar mit der Deckeleinheit 24c verbunden. Die Kontaktierungseinheit 14c umfasst ein Fixierelement 26c. Das Fixierelement 26c ist zu einer mechanischen Fixierung der Deckeleinheit 24c an einem Werkzeug 36c vorgesehen (Figur 6).

Die Kontaktierungseinheit 14c umfasst ein Steckverbindungselement 40c. Die Kontaktelemente 16c, 18c, 20c sind am Steckverbindungselement 40c angeordnet. Das Fixierelement 26c ist einstückig mit dem Steckverbindungselement 40c ausgebildet. Das Fixierelement 26c ist ferner einstückig mit einer Deckelwandung 42c der Deckeleinheit 24c ausgebildet. Die Kontaktelemente 16c, 18c, 20c sind teilweise am Fixierelement 26c angeordnet. Genauer gesagt sind die Kontaktelemente 16c, 18c, 20c teilweise vom Fixierelement 26c umschlossen. Das Fixierelement 26c ist zu einem Einbringen und/oder Verrasten in einer formkomplementären Buchse (nicht dargestellt) vorgesehen.

## Patentansprüche

1. Elektronikmodul (10a; 10b; 10c), insbesondere für eine Handwerkzeugmaschine, mit zumindest einer Elektronikeinheit (12a; 12b; 12c), mit zumindest einer Kontaktierungseinheit (14a; 14b; 14c), die zumindest ein Kontaktelement (16a - 16c, 18a - 18c, 20a - 20c) umfasst, das zu einer Kontaktierung einer elektrischen Energiequelle (22a) und/oder zu einer Übertragung von elektronischen Daten vorgesehen ist, mit zumindest einem Energiespeicheraufnahmebereich (72a; 72b; 72c), der an der Kontaktierungseinheit (14a; 14b; 14c) anliegend angeordnet ist, und mit zumindest einer Deckeleinheit (24a; 24b; 24c), wobei die Elektronikeinheit (12a; 12b; 12c) unverlierbar mit der zumindest einen Deckeleinheit (24a; 24b; 24c) verbunden ist, wobei der Energiespeicheraufnahmebereich (72a; 72b; 72c) an einer der Deckeleinheit (24a; 24b; 24c) abgewandten Seite (68a; 68b; 68c) der Elektronikeinheit (12a; 12b; 12c) angeordnet ist, wobei die zumindest eine Kontaktierungseinheit (14a; 14b; 14c) zumindest ein Fixierelement (26a; 26b; 26c) umfasst, das zu einer mechanischen Fixierung der Deckeleinheit (24a; 24b; 24c) an einem Werkzeug (36a; 36b; 36c) oder an einer Gehäuseeinheit (46a; 46b; 46c) des Elektronikmoduls (10a; 10b; 10c) vorgesehen ist, wobei das zumindest eine Kontaktelement (16a - 16c, 18a - 18c, 20a - 20c) zumindest teilweise am zumindest einen Fixierelement (26a; 26b; 26c) angeordnet ist, und wobei die Elektronikeinheit (12a; 12b; 12c) zumindest eine Kommunikationseinheit (70a; 70b; 70c) zu einer kabelgebundenen und/oder drahtlosen Datenübertragung mit dem Werkzeug (36a; 36b; 36c) und/oder zu einem Datenaustausch mit einem externen Gerät umfasst, **dadurch gekennzeichnet, dass** das zumindest eine Kontaktelement (16a - 16c, 18a - 18c, 20a - 20c) zumindest teilweise innerhalb einer Deckelwandung (42a; 42b; 42c) der zumindest einen Deckeleinheit (24a; 24b; 24c) angeordnet ist, und wobei die Deckeleinheit (24a; 24b; 24c) an einer der Elektronikeinheit (12a; 12b; 12c) abgewandten Seite eine geschlossene Oberfläche aufweist, welche sich über die Elektronikeinheit (12a; 12b; 12c) und die Kontaktierungseinheit (14a; 14b; 14c) erstreckt.

2. Elektronikmodul (10a; 10b; 10c) nach Anspruch 1, **dadurch gekennzeichnet, dass** das zumindest eine Kontaktelement (16a, 18a, 20a) zu einer axialen Kontaktierung mit der elektrischen Energiequelle und/oder einer weiteren Elektronikeinheit (28a) vorgesehen ist.

3. Elektronikmodul (10a; 10b; 10c) nach Anspruch 1 oder 2, **dadurch gekennzeichnet, dass** das zumindest eine Kontaktelement (16b, 18b, 20b) zu einer radialen Kontaktierung mit der elektrischen Energiequelle und/oder einer weiteren Elektronikeinheit (28b) vorgesehen ist.

4. Elektronikmodul (10a; 10b; 10c) nach einem der vorhergehenden Ansprüche, **gekennzeichnet durch** zumindest eine Erweiterungseinheit (30a), die mit der zumindest einen Elektronikeinheit (12a) koppelbar ausgebildet ist und die zu einer Funktionserweiterung der zumindest einen Elektronikeinheit (12a) vorgesehen ist.

5. Elektronikmodul (10a; 10b; 10c) nach Anspruch 4, **dadurch gekennzeichnet, dass** die zumindest eine Erweiterungseinheit (30a) zumindest ein Bodenelement (32a) aufweist, das zumindest zu einem Verschließen eines Aufnahmeraums (34a) vorgesehen ist, in welchem die zumindest eine Elektronikeinheit (12a) angeordnet ist.

6. Elektronikmodul (10a; 10b; 10c) nach Anspruch 4 oder 5, **dadurch gekennzeichnet, dass** die zumindest eine Erweiterungseinheit (30a) zumindest eine Kommunikationseinheit (38a) umfasst, die zu einer drahtlosen Datenübertragung vorgesehen ist.

7. Elektronikmodul (10a; 10b; 10c) nach einem der vorhergehenden Ansprüche, **dadurch gekennzeichnet, dass** die zumindest eine Kontaktierungseinheit (14c) zumindest ein Steckverbindungselement (40c) umfasst, an welchem das zumindest eine Kontaktelement (16c, 18c, 20c) angeordnet ist.

8. Elektronikmodul (10a; 10b; 10c) nach einem der vorhergehenden Ansprüche, **dadurch gekennzeichnet, dass** das zumindest eine Fixierelement (26a; 26b) einen Bajonettverschluss ausbildet.

9. Werkzeug (36a; 36b; 36c), insbesondere Handwerkzeugmaschine, mit einem Elektronikmodul (10a; 10b; 10c) nach einem der vorhergehenden Ansprüche.

## Claims

1. Electronic module (10a; 10b; 10c), in particular for a hand-held machine tool, with at least one electronic unit (12a; 12b; 12c), with at least one contacting unit (14a; 14b; 14c) which comprises at least one contact element (16a-16c, 18a-18c, 20a-20c) which has been provided for contacting a source of electrical energy (22a) and/or for transmitting electronic data, with at least one energy-store receiving region (72a; 72b; 72c) which is arranged bearing against the contacting unit (14a; 14b; 14c), and with at least one cover unit (24a; 24b; 24c), said electronic unit (12a; 12b; 12c) being connected to the at least one cover unit (24a; 24b; 24c) in captive manner, the energy-store receiving region (72a; 72b; 72c) being arranged on a side (68a; 68b; 68c) of the electronic unit (12a; 12b; 12c) facing away from the cover unit (24a; 24b; 24c), the at least one contacting unit (14a; 14b; 14c) including at least one fixing element (26a; 26b; 26c) which has been provided for mechanical fixing of the cover unit (24a; 24b; 24c) to a tool (36a; 36b; 36c) or to a housing unit (46a; 46b; 46c) of the electronic module (10a; 10b; 10c), said at least one contact element (16a-16c, 18a-18c, 20a-20c) being at least partially arranged on the at least one fixing element (26a, 26b; 26c), and the electronic unit (12a; 12b; 12c) including at least one communication unit (70a; 70b; 70c) for a hard-wired and/or wireless transmission of data with the tool (36a; 36b; 36c) and/or for an exchange of data with an external instrument, **characterized in that** the at least one contact element (16a-16c, 18a-18c, 20a-20c) is arranged at least partially within a cover wall (42a; 42b; 42c) of the at least one cover unit (24a; 24b; 24c), and, on a side facing away from the electronic unit (12a; 12b; 12c), said cover unit (24a; 24b; 24c) exhibiting a closed surface which extends over the electronic unit (12a; 12b; 12c) and the contacting unit (14a; 14b; 14c).

2. Electronic module (10a; 10b; 10c) according to Claim 1, **characterized in that** the at least one contact element (16a, 18a, 20a) has been provided for an axial contacting with the source of electrical energy and/or with a further electronic unit (28a).

3. Electronic module (10a; 10b; 10c) according to Claim 1 or 2, **characterized in that** the at least one contact element (16b, 18b, 20b) has been provided for a radial contacting with the source of electrical energy and/or with a further electronic unit (28b).

4. Electronic module (10a; 10b; 10c) according to one of the preceding claims, **characterized by** at least one expansion unit (30a) which has been designed to be capable of coupling with the at least one electronic unit (12a) and which has been provided for a functional expansion of the at least one electronic unit (12a).

5. Electronic module (10a; 10b; 10c) according to Claim 4, **characterized in that** the at least one expansion unit (30a) exhibits at least one bottom element (32a) which has been provided at least for sealing a receiving space (34a) in which the at least one electronic unit (12a) is arranged.

6. Electronic module (10a; 10b; 10c) according to Claim 4 or 5, **characterized in that** the at least one expansion unit (30a) includes at least one communication unit (38a) which has been provided for a wireless transmission of data.

7. Electronic module (10a; 10b; 10c) according to one of the preceding claims, **characterized in that** the at least one contacting unit (14c) includes at least one plug-in connection element (40c) on which the at least one contact element (16c, 18c, 20c) is arranged.

8. Electronic module (10a; 10b; 10c) according to one of the preceding claims, **characterized in that** the at least one fixing element (26a; 26b) takes the form of a bayonet closure.

9. Tool (36a; 36b; 36c), in particular a hand-held machine tool, with an electronic module (10a; 10b; 10c) according to one of the preceding claims.

## Revendications

1. Module électronique (10a ; 10b ; 10c), en particulier destiné à un outil à main électrique, ledit module comprenant au moins une unité électronique (12a ; 12b ; 12c), au moins une unité de contact (14a ; 14b ; 14c) qui comprend au moins un élément de contact (16a-16c, 18a-18c, 20a-20c) qui est prévu pour venir en contact avec une source d'énergie électrique (22a) et/ou pour transmettre des données électroniques, au moins une zone de réception d'accumulateur d'énergie (72a ; 72b ; 72c) qui est disposée en appui sur l'unité de contact (14a ; 14b ; 14c) et au moins une unité formant capot (24a ; 24b ; 24c), l'unité électronique (12a ; 12b ; 12c) étant reliée de manière imperdable à l'au moins une unité formant capot (24a ; 24b ; 24c), la zone de réception d'accumulateur d'énergie (72a ; 72b ; 72c) étant disposée sur un côté (68a ; 68b ; 68c) de l'unité électronique (12a ; 12b ; 12c) qui est opposé à l'unité formant capot (24a ; 24b ; 24c), l'au moins une unité de contact (14a ; 14b ; 14c) comprenant au moins un élément de fixation (26a ; 26b ; 26c) qui est prévu pour fixer mécaniquement l'unité formant capot (24a ; 24b ; 24c) à un outil (36a ; 36b ; 36c) ou à une unité formant boîtier (46a ; 46b ; 46c) du module électronique (10a ; 10b ; 10c), l'au moins un élément de contact (16a-16c, 18a-18c, 20a, 20c) étant au moins partiellement disposé sur l'au moins un élément de fixation (26a ; 26b ; 26c), et l'unité électronique (12a ; 12b ; 12c) comprenant au moins une unité de communication (70a ; 70b ; 70c) destinée à la transmission de données filaire et/ou sans fil avec l'outil (36a ; 36b ; 36c) et/ou à l'échange de données avec un dispositif extérieur,
**caractérisé en ce que** l'au moins un élément de contact (16a-16c, 18a-18c, 20a-20c) est disposé au moins partiellement à l'intérieur d'une paroi de capot (42a ; 42b ; 42c) de l'au moins une unité formant capot (24a ; 24b ; 24c), et l'unité formant capot (24a ; 24b ; 24c) comportant sur un côté opposé à l'unité électronique (12a ; 12b ; 12c) une surface fermée qui s'étend sur l'unité électronique (12a ; 12b ; 12c) et l'unité de contact (14a ; 14b ; 14c).

2. Module électronique (10a; 10b ; 10c) selon la revendication 1, **caractérisé en ce que** l'au moins un élément de contact (16a, 18a, 20a) est prévu pour réaliser un contact axial avec la source d'énergie électrique et/ou une autre unité électronique (28a).

3. Module électronique (10a ; 10b ; 10c) selon la revendication 1 ou 2, **caractérisé en ce que** l'au moins un élément de contact (16b, 18b, 20b) est prévu pour réaliser un contact radial avec la source d'énergie électrique et/ou une autre unité électronique (28b).

4. Module électronique (10a ; 10b ; 10c) selon l'une des revendications précédentes, **caractérisé par** au moins une unité d'extension (30a) qui est conçue pour se coupler à l'au moins une unité électronique (12a) et qui est prévue pour réaliser une extension fonctionnelle de l'au moins une unité électronique (12a) .

5. Module électronique (10a ; 10b ; 10c) selon la revendication 4, **caractérisé en ce que** l'au moins une unité d'extension (30a) comporte au moins un élément de fond (32a) qui est prévu au moins pour fermer un espace de réception (34a) dans lequel l'au moins une unité électronique (12a) est disposée.

6. Module électronique (10a ; 10b ; 10c) selon la revendication 4 ou 5, **caractérisé en ce que** l'au moins une unité d'extension (30a) comprend au moins une unité de communication (38a) qui est prévue pour la transmission de données sans fil.

7. Module électronique (10a ; 10b ; 10c) selon l'une des revendications précédentes, **caractérisé en ce que** l'au moins une unité de contact (14c) comprend au moins un élément de liaison enfichable (40c) sur lequel l'au moins un élément de contact (16c, 18c, 20c) est disposé.

8. Module électronique (10a ; 10b ; 10c) selon l'une des revendications précédentes, **caractérisé en ce que** l'au moins un élément de fixation (26a ; 26b) forme une fermeture à baïonnette.

9. Outil (36a ; 36b ; 36c), en particulier outil électrique à main, comprenant un module électronique (10a ; 10b ; 10c) selon l'une des revendications précédentes.
